Europäisches Patentamt

European Patent Office

Office européen des brevets

(19)

(11) Veröffentlichungsnummer: **0 179 348 B1**

(12) **EUROPÄISCHE PATENTSCHRIFT**

(45) Veröffentlichungstag der Patentschrift: **02.10.91**

(51) Int. Cl.⁵: **H05K 7/10**, H01R 13/514, H02B 1/04

(21) Anmeldenummer: **85112731.6**

(22) Anmeldetag: **08.10.85**

(54) **Aufsteckelement.**

(30) Priorität: **23.10.84 DE 3438824**

(43) Veröffentlichungstag der Anmeldung:
**30.04.86 Patentblatt 86/18**

(45) Bekanntmachung des Hinweises auf die
Patenterteilung:
**02.10.91 Patentblatt 91/40**

(84) Benannte Vertragsstaaten:
**AT BE CH DE IT LI NL**

(56) Entgegenhaltungen:
**DE-B- 2 835 346**
**FR-A- 2 223 937**
**US-A- 4 113 340**

(73) Patentinhaber: **Siemens Aktiengesellschaft**
**Wittelsbacherplatz 2**
**W-8000 München 2(DE)**

(72) Erfinder: **Kienast, Fritz, Dipl.-Ing.**
**Kleistrasse 2**
**W-8520 Erlangen(DE)**

## Beschreibung

Die Erfindung bezieht sich auf ein Aufsteckelement für eine Kontaktleiste, deren Enden mit jeweils wenigstens einem Flachstecker versehen sind, und die mehrere in einer Matrix angeordnete Steckkontakte hat, wobei das Aufsteckelement aus einem mit elektrischen Bauelementen versehenen Gehäuse besteht.

Bei derartigen im Handel erhältlichen Aufsteckelementen können mechanische Belastungen, beispielsweise Vibrationen, die Qualität der Steckverbindungen beeinflussen. Außerdem kann sich bei einer hohen oder lang andauernden mechanischen Belastung die Steckverbindung lösen und das Aufsteckelement verloren gehen.

Es ist ein Kontaktsystem der Firma AMP aus dem Firmenprospekt AMP Positive Lock 094-EU, D/E1-3/84 bekannt, das für den Einsatz im Fahrzeugbau entwickelt wurde, wo Vibrationen und mechanische Qualität normaler Steckverbindungen auf Dauer beeinflußt werden können. Besondere Merkmale dieses Kontaktsystems sind die geringen Aufsteckkräfte bei gleichzeitig hoher mechanischer Haltekraft. Erreicht wird dieses durch ein verrastendes Federelement in der Steckhülse. Der Flachstecker dieses Kontaktsystems drückt beim Aufstecken den Rasthaken der Steckhülse nach unten. Bei Erreichen der Endstellung rastet der Rasthaken in das Rastloch des Flachsteckers ein. Durch Zurückziehen des Gehäuses wird die Federlasche soweit heruntergedrückt, daß der Rasthaken den Flachstecker wieder freigibt.

Der Erfindung liegt nun die Aufgabe zugrunde, ein Aufsteckelement für eine Kontaktleiste der eingangs genannten Art so auszubilden, daß das Aufsteckelement mit einer Kontaktleiste eine vibrations- und/oder rüttelfeste Steckverbindung bilden.

Diese Aufgabe wird erfindungsgemäß dadurch gelöst, daß das Gehäuse mit Kontaktelementen, mit wenigstens einer verriegelbaren Flachsteckhülse und mit Langlochbohrungen versehen ist, deren Öffnung in der der Kontaktleiste zugewandten Fläche angeordnet sind, daß die elektrischen Bauelemente elektrisch leitend mit den Kontaktelementen verbunden sind, und daß die Zuordnung der Flachsteckhülse und eines Kontaktelementes und der Kontaktelemente zueinander mit der Zuordnung eines Flachsteckers und eines Steckkontaktes und der Steckkontakte zueinander übereinstimmt. Somit erhält man ein Aufsteckelement mit geringen Aufsteckkräften bei gleichzeitig hoher mechanischer Haltekraft, dessen Steckverbindung mit einer Kontaktleiste vibrations- und/oder rüttelfest ist. Durch diese Gestaltung des Aufsteckelementes wird wenigstens ein Flachstecker der Kontaktleiste, der üblicherweise für elektrische Potentiale vorgesehen ist, nur zu seiner mechanischen Befestigung auf derselben verwendet.

Als verriegelbare Flachsteckhülse kann dabei das eingangs erwähnte System der Firma AMP oder eine beliebige andere, auf dem Markt erhältliche verriegelbare Flachsteckhülse, verwendet werden`

In einer bevorzugten Ausführungsform des Aufsteckelementes ist das Gehäuse im Bereich der Kontaktelemente mit einem Absatz versehen und die Öffnungen der Kontaktelemente sind in der der Kontaktleiste zugewandten Schmalfläche des Absatzes angeordnet. Dadurch können die Steckkontakte der Kontaktleiste, die für den elektrischen Anschluß der elektrischen Bauelemente des Aufsteckelementes vorgesehen sind, noch mit zwei Wickeln einer Wire-Wrap-Verdrahtung versehen werden, die zwischen der Kontaktleiste und der Schmalfläche des Absatzes des Aufsteckelementes angeordnet sind.

In einer weiteren vorteilhaften Ausführungsform sind die Seitenflächen des Gehäuses des Aufsteckelementes im Bereich der elektrischen Bauelemente mit vertikalen Schlitzen versehen. Durch dieses Gestaltungsmerkmal des Gehäuses kann man überprüfen, ob die elektrischen Bauelemente, beispielsweise Dioden, gemäß ihrer Verwendung richtig im Gehäuse angeordnet sind.

Zur weiteren Erläuterung der Erfindung wird auf die Zeichnung Bezug genommen, in der ein Ausführungsbeispiel des Aufsteckelementes nach der Erfindung schematisch veranschaulicht ist.

Figur 1   zeigt eine erste Ausführungsform des Aufsteckelementes gemäß der Erfindung und in

Figur 2   ist eine zweite Ausführungsform des Aufsteckelementes dargestellt.

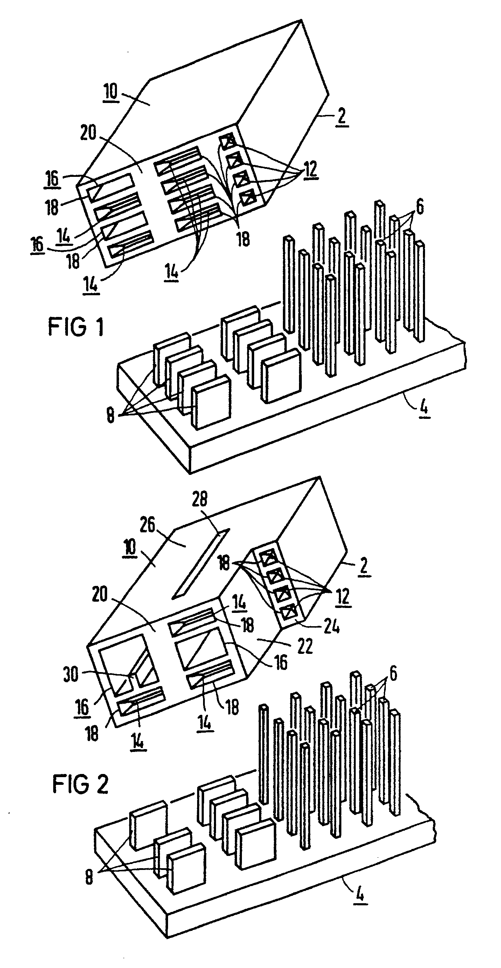

In der Ausführungsform nach Figur 1 ist ein Aufsteckelement 2 und eine Kontaktleiste 4 dargestellt. Die Kotnaktleiste 4, auch bekannt als Steckbrett, enthält mehrere in einer Matrix angeordnete Steckkontakte 6 und an ihren Enden sind jeweils mehrere Flachstecker 8 vorgesehen. Als Steckkontakte 6 sind beispielsweise die im Handel erhältlichen Anschlußstifte für ein lötfreies Anschlußverfahren, beispielsweise die Wire-Wrap-Technik, vorgesehen. Die Flachstecker 8 sind ebenfalls in einer Matrix angeordnet. Wenigstens ein Flachstecker 8 der Kontaktleiste 4 ist nur zur mechanischen Befestigung des Aufsteckelementes 2 vorgesehen. Das Aufsteckelement 2 für die Kontaktleiste 4 besteht aus einem mit elektrischen Bauelementen versehenen Gehäuse 10. Als elektrische Bauelemente können beispielsweise Dioden oder Zenerdioden vorgesehen sein. Diese elektrischen Bauelemente sind mit Kontaktelementen 12, die im Gehäuse 10 angeordnet sind, gemäß ihrer Verwendung elektrisch leitend verbunden. Ein solches mit Zenerdioden versehenes Aufsteckelement, das auf eine Kontaktleiste aufgesteckt ist, kann die mittels der Kontaktleiste miteinander verdrahteten Baugruppen vor unzulässig hohen Spannungen an deren Stromversorgungseingängen schützen. Außerdem ist das Gehäuse 10 mit verriegelbaren Flachsteckhülsen 14 und mit Langlochbohrungen 16 versehen, deren Öffnungen 18 in der der Kontaktleiste 4 zugewandten Fläche 20 angeordnet sind. Die Zuordnung der verriegelbaren Flachsteckhülsen 14 und der Kontaktelemente 12 und der Kontaktelemente 12 zueinander des Aufsteckelementes 2 entspricht der Zuordnung der Flachstecker 8 und der Steckkontakte 6 und der Steckkontakte 6 zueinander der Kontaktleiste 4. Somit erhält man ein Aufsteckelement 2 mit geringen Aufsteckkräften bei gleichzeitig hoher mechanischer Haltekraft, dessen Steckverbindung mit einer Kontaktleiste 4 vibrations- und/oder rüttelfest ist.

In der Figur 2 ist ein Aufsteckelement 2 dargestellt, dessen Gehäuse 10 im Bereich der Kontaktelemente 12 mit einem Absatz 22 versehen ist. Die Öffnungen 18 dieser Kontaktelemente 12 sind in einer der Kontaktleiste 4 zugewandten Schmalfläche 24 des Absatzes 22 angeordnet. Die Schmalfläche 24 des Absatzes 22 und die der Kontaktleiste 4 zugewandte Fläche 20 des Aufsteckelementes 2 sind mit einem vorbestimmten Abstand parallel zueinander angeordnet. Dieser Abstand ist wenigstens so gewählt, daß jeweils zwei Wickel einer Wire-Wrap-Verdrahtung auf die für die elektrische Stromversorgung der elektrischen Bauelemente des Aufsteckelementes 2 vorgesehenen Steckkontakte 6 angeordnet werden können. Außerdem sind die Seitenflächen 26 des Gehäuses 10 des Aufsteckelementes 2 im Bereich der elektrischen Bauelemente mit vertikalen Schlitzen 28 versehen. Dadurch kann man überprüfen, ob die elektrischen Bauelemente, beispielsweise Dioden, gemäß ihrer Verwendung richtig im Gehäuse 10 angeordnet sind. Ferner können die Langlochbohrungen 16 jeweils mit einer Rippe 30 versehen sein, die senkrecht zu einer Seitenfläche der Langlochbohrung 16 angeordnet ist. Diese Rippen 30 verhindern ein verkehrtes Stecken des Aufsteckelementes 2, insbesondere eines Zenerdioden-Aufsteckelementes, auf die Kontaktleiste 4. Somit erhält man ein Aufsteckelement 2, beispielsweise ein Zenerdioden-Aufsteckelement zum Schutz der Baugruppen gegen Überspannungen von einer Stromversorgung, dessen Steckverbindung mit der Kontaktleiste 4 vibrations- und/oder rüttelfest ist, wobei die Steckelemente 6, die für die elektrische Stromversorgung der Bauelemente des Aufsteckelementes 2 vorgesehen sind, außerdem zur Verdrahtung von Baugruppen verwendet werden können.

**Patentansprüche**

1. Aufsteckelement (2) für eine Kontaktleiste (4), deren Enden jeweils mit wenigstens einem Flachstecker (8) versehen sind, und die mehrere in einer Matrix angeordnete Steckkontakte (6) hat, wobei das Aufsteckelement (2) aus einem mit elektrischen Bauelementen versehenen Gehäuse (10) besteht, **dadurch gekennzeichnet,** daß das Gehäuse (10) mit Kontaktelementen (12), mit wenigstens einer verriegelbaren Flachsteckhülse (14) und mit Langlochbohrungen (16) versehen ist, deren Öffnungen (18) in der der Kontaktleiste (4) zugewandten Fläche (20) angeordnet sind, daß die elektrischen Bauelemente elektrisch leitend mit den Kontaktelementen (12) verbunden sind, und daß die Zuordnung der Flachsteckhülse (14) und eines Kontaktelementes (12) und der Kontaktelemente (12) zueinander mit der Zuordnung eines Flachsteckers (8) und eines Steckkontaktes (6) und der Steckkontakte (6) zueinander für eine steckbare Verbindung übereinstimmt.

2. Aufsteckelement (2) nach Anspruch 1, **dadurch gekennzeichnet,** daß das Gehäuse (10) im Bereich der Kontaktelemente (12) mit einem Absatz (22) versehen ist und die Öffnungen (18) der Kontaktelemente (12) in einer der Kontaktleiste (4) zugewandten Schmalfläche (24) des Absatzes (22) angeordnet sind.

3. Aufsteckelement (2) nach Anspruch 1, **dadurch gekennzeichnet,** daß die Seitenflächen (26) des Gehäuses (10) im Bereich der elektrischen Bauelemente mit vertikalen Schlitzen (28) versehen sind.

**Claims**

1. A plug-in element (2) for a contact strip (4), the ends of which are provided in each case with at least one flat plug (8), and which has several plug contacts (6) arranged in a matrix, wherein the plug-in element (2) consists of a housing (10) provided with electrical components, characterised in that the housing (10) with contact elements (12) is provided with at least one lockable flat push-on sleeve (14) and with longitudinal holes (16), the openings (18) of which are arranged in the face (20), facing the contact strip (4), in that the electric components are connected in an electrically conducting manner to the contact elements (12), and in that the allocation of the flat push-on sleeve (14) and of a contact element (12) and the contact elements (12) to each other, corresponds with the allocation of a flat plug (8) and a plug contact (6) and the plug contacts (6) to each other for a plug-in connection.

2. A plug-in element (2) according to claim 1, characterised in that the housing (10) is provided in the region of the contact elements (12) with a step (22) and the openings (18) of the contact elements (12) are arranged in a narrow face (24) of the step (22), facing the contact strip (4).

3. A plug-in element (2) according to claim 1, characterised in that the side faces (26) of the housing (10) are provided in the region of the electric components with vertical slots (28).

**Revendications**

1. Élément enfichable (2) pour une barrette à contacts (4), dont les extrémités comportent respectivement au moins un connecteur plat (8) et qui possède plusieurs contacts à enfichage (6) disposés suivant une matrice, l'élément enfichable (2) étant constitué par un boîtier (10) équipé de composants électriques, caractérisé par le fait que le boîtier (10) comporte des éléments de contact (12), au moins une douille verrouillable (14) pour connecteur plat et des perçages en forme de trous allongés (16), dont les ouvertures (18) débouchent dans la surface (20) tournée vers la barrette à contacts (4), que les composants électriques sont raccordés d'une manière électriquement conductrice aux éléments de contact (12) et que l'association de la douille (14) pour connecteur plat et d'un élément de contact (12) et des éléments de contact (12) entre eux correspond à l'association d'un connecteur plat (8) et d'un contact à enfichage (6) et des contacts à enfichage (6) entre eux pour une liaison enfichable.

2. Élément enfichable (2) suivant la revendication 1, caractérisé par le fait que le boîtier (10) comporte un décrochement (22) dans la zone des éléments de contact (12) et que les ouvertures (18) des éléments de contact (12) sont disposées dans une surface étroite (24), tournée vers la barrette à contacts (4), du décrochement (22).

3. Élément enfichable (2) suivant la revendication 1, caractérisé par le fait que les surfaces latérales (26) du boîtier (10) comportent des fentes verticales (28) dans la zone des composants électriques.

FIG 1

FIG 2